# EUROPEAN PATENT SPECIFICATION

(11) **EP 4 153 530 B1**
(45) Date of publication and mention of the grant of the patent: **25.12.2024**
(21) Application number: 21727209.5
(22) Date of filing: 18.05.2021
(51) Int. Cl.: B81B 5/00, G01P 15/18, G01P 15/097

(54) **DUAL AND TRIPLE AXIS ACCELEROMETERS**
DOPPEL- UND DREIACHSIGE BESCHLEUNIGUNGSMESSER
ACCÉLÉROMÈTRES À AXE DOUBLE ET TRIPLE

(30) Priority: 19.05.2020 GB 202007379
(43) Date of publication of application: 29.03.2023
(73) Proprietor: Silicon Microgravity Limited, Cambridge Innovation Park, Waterbeach, Cambridgeshire CB25 9GL (GB)
(72) Inventor: SESHIA, Ashwin, Cambridge, Cambridgeshire CB3 0FF (GB); SOBREVIELA, Guillermo, Cambridge, Cambridgeshire CB25 9GL (GB)
(74) Representative: Reddie & Grose LLP
(86) International application number: PCT/GB2021/051196
(87) International publication number: WO 2021/234371

(56) References cited:
- US-A1- 2007 209 437
- US-A1- 2013 214 367
- US-A1- 2015 226 762

## Description

### Field of the Invention

The present invention relates to accelerometers. In particular, the invention relates to multi-axis accelerometers that can be readily manufactured and are capable of sensing in two or three orthogonal directions.

### Background to the invention

A resonant accelerometer is an oscillator whose output resonant frequency is a function of an input measurand. In other words, the output of a resonant accelerometer corresponds to the shift in resonant frequency of a mechanical microstructure that gets tuned in accordance to a change in a physical quantity to be measured.

There has been an increased interest over the past few years in the development of high precision micro-machined 'all-silicon' resonant micro-accelerometers. This interest has been triggered due to the recent growth in demand for miniature high precision motion accelerometers within the aerospace, automotive and even the consumer-electronics markets. Resonant micro-accelerometers fabricated using silicon micromachining techniques present a number of significant advantages, the biggest being economy. These silicon resonant micro-accelerometers not only boast improved sensitivity and resolution relative to their more traditional capacitive detection based counterparts with similar device footprints, but have also been shown to provide enhanced dynamic range making them ideal candidates for potential application in numerous motion sensing applications within the identified markets. One potential sensing application is gravimetry. Resonant accelerometers can be designed to provide a low-noise response for near-DC measurements (suitable for applications in gravimetry) and a wide dynamic range enabling measurements over the entire +/-1g regime.

However, most of these accelerometers still remain uniaxial or biaxial, consequently restricting their functionality and practical applicability to those applications that do not demand sophisticated three dimensional (3D) motion control. Three uniaxial, orthogonally oriented resonant accelerometers can be employed for a precise three dimensional acceleration measurement. But such implementations correspondingly increase the cost, size and power requirements of the device. Also, such implementations require very precise alignment of the separate accelerometers relative to each other to provide accurate measurement.

It is an object of the present invention to provide a resonant accelerometer that allows for two and three dimensional acceleration read out in a single device package that is both small and provides for accurate measurement.

US 2015/226762 A1 discloses a dual-axis accelerometer. The dual-axis accelerometer comprises a single suspended silicon proof mass held within a dual-axis stage. The dual-axis stage comprises four platforms that are coupled to the proof mass at each corner of the proof mass, by flexures. The platforms are coupled to a surrounding frame by flexures. The platforms are each mechanically coupled to vibratory double ended tuning fork resonators. The acceleration of the proof mass results in strain on the resonators, altering their resonant frequency. US 2013/214367 A1 discloses an integrated MEMS inertial sensor device. The device is a two proof-mass design with concentrically configured proof masses and frame structures. A first proof mass is connected to a first frame by springs configured to allow translation along an X-axis. The first frame is coupled to a second frame by springs configured to allow translation along a Y-axis. The second frame is coupled to anchors. The device further discloses a second proof mass, which is disclosed to be a Z proof mass and is coupled by springs to the anchors. The springs can allow rotational translation about the X-axis, allowing displacement of the second proof mass in a Z direction.

### Summary of the Invention

The invention is defined in the appended independent claims, to which reference should be made. Optional features are set out in the dependent claims.

In a first aspect of the invention, there is provided an accelerometer comprising:
a frame;
a first proof mass suspended from the frame by one or more flexures to move relative to the frame along a first axis;
a first resonant element assembly fixed between the frame and the first proof mass, wherein movement of the proof mass along the first axis relative to the frame exerts a strain on the first resonant element that affects the resonant behaviour of the first resonant element assembly;
a second proof mass suspended from the frame by one or more flexures to move relative to the frame along a second axis,
a second resonant element assembly fixed between the frame and the second proof mass, wherein movement of the second proof mass along the second axis relative to the frame exerts a strain on the second resonant element that affects the resonant behaviour of the second resonant element assembly;
wherein the second proof mass surrounds the first proof mass and the first resonant element assembly.

An accelerometer in accordance with the invention has the advantage of providing for two axes of acceleration measurement in a single, compact device. The sensitive axes can be aligned at the chip level if the accelerometer is fabricated from a single piece of semiconductor material. The two sensitive axes are mechanically decoupled from one another so that cross talk between two axes of measurement is minimised.

Advantageously, a centre of mass of the first proof mass is substantially coincident with a centre of mass of the second proof mass. This ensures that both masses respond to inertial forces acting at the same effective location.

Advantageously, the accelerometer is fabricated so that the first proof mass and the second proof mass are coplanar and lie in a plane defined by the first and second axes. This allows for straightforward fabrication of the accelerometer using a layered structure but with few layers, resulting in a compact accelerometer.

The first and second axes may be orthogonal to one another. It is typically desirable to provide orthogonal measurement axes as this simplifies the processing of the accelerometer outputs.

Advantageously, the first proof mass and second proof mass are of substantially equal mass. This provides for equal sensitivity along the first and second axes.

The accelerometer may be a micro electrical mechanical systems (MEMS) device. The frame, first proof mass, second proof mass and flexures may be formed from a single piece of semiconductor material, such as silicon. This allows for small and robust accelerometers to manufactured using well established fabrication techniques.

The first and second resonant element assemblies may be different to another. In particular the first and second resonant elements may be constructed to have significantly different resonant frequencies to one another. This reduces the potential for cross-talk between the outputs from the first and second resonant elements. The resonant element assemblies may be formed from the single piece of semiconductor material.

The accelerometer may comprise a third resonant element assembly fixed between the frame and the first proof mass, wherein movement of the proof mass along the first axis relative to the frame exerts a strain on the third resonant element that affects the resonant behaviour of the third resonant element assembly.

The third resonant element assembly may be substantially identical to the first resonant element assembly and is fixed on an opposite side of the first proof mass to the first resonant assembly in the direction of the first axis. The provision of a third resonant element in this way allows for common mode rejection of changes in the output due to effects such as variation in temperature or pressure.

The accelerometer may comprise a fourth resonant element assembly fixed between the frame and the second proof mass, wherein movement of the proof mass along the second axis relative to the frame exerts a strain on the fourth resonant element that affects the resonant behaviour of the fourth resonant element assembly.

The fourth resonant element assembly may be substantially identical to the second resonant element assembly and is fixed on an opposite side of the second proof mass to the second resonant assembly in the direction of the second axis. This again allows for common mode rejection.

One or more of the resonant element assemblies may comprise one or more resonant elements. The one or more resonant elements may be double ended tuning fork (DETF) resonant elements, for example. One or more of the resonant element assemblies may comprise a pair of weakly coupled resonant elements. Mode localisation in weakly coupled resonant elements can be used to provide a highly sensitive measure of acceleration.

The one or more of the resonant element assemblies may comprise a drive electrode though which a drive signal is applied to the resonant element assembly. At least one resonant element is driven into resonance by the drive signal.

The one or more resonant element assemblies may comprise one or more sense electrodes, through which a frequency of vibration or an amplitude of vibration of at least one resonant element can be detected. A control loop comprising both the drive electrode and the sense electrode may be used to maintain a resonant element assembly vibrating in resonance. Changes in the resonant frequency, or in the case of coupled resonant elements, a change in the relative amplitude of vibration of the couple resonant elements, can be used to provide a measure of acceleration.

The accelerometer may further comprise at least one lever linking the first proof mass or second proof mass to at least one of the resonant elements. The lever can be used to amplify the strain modulation experienced by the at least one resonant element as a result of movement of the first proof mass or second proof mass. This can improve the sensitivity of the accelerometer.

The accelerometer may comprise one or more electrodes adjacent the first proof mass or second proof mass and spaced from the first proof mass or the second proof mass along a third axis orthogonal to the first axis and the second axis. The flexures suspending the first proof mass or second proof mass from the frame may allow the first proof mass or second proof mass to move relative to the frame along the third axis. In other words, the first proof mass or second proof mass may be moveable towards or away from the one or more electrodes. This has the advantage of providing a third axis of acceleration measurement in a single, compact device.

The one or more electrodes may be used to indicate the proximity of the first proof mass or the second proof to the respective electrode to indicate the acceleration in the third axis. For example, the accelerometer may be configured to measure capacitance wherein the capacitance is dependent on the gap between the respective electrode and proof mass.

Alternatively, the one or more electrodes may be configured to drive the first or second proof mass to oscillate in the third axis. The acceleration in third axis may be determined by the accelerometer based on the oscillatory behaviour of the first or second proof mass. In particular, changes in the resonant frequency of the proof mass or masses can be measured based on signals from the one or more electrodes to allow acceleration along the third axis to be determined.

The one or more electrodes may be configured to calibrate the accelerometer. It may be advantageous to align the proof mass with a field in the third axis. The one or more electrodes may be configured to apply forces on the first or second proof mass to maintain this alignment.

The flexures that suspend the first proof mass from the frame may be positioned inside first proof mass. Similarly, the flexures that suspend the second proof mass from the frame may be positioned inside second proof mass. This may provide a compact accelerometer design.

In another aspect of the invention, there is provided a gravimeter comprising an accelerometer according to the first aspect of the invention.

### Brief Description of the Drawings

Embodiments of the present invention will now be described, by way of example only, with reference to the accompanying drawings, in which:
Figure 1 is a schematic illustration of an accelerometer in accordance with an embodiment of the invention;
Figure 2 is a schematic illustration of drive and sense electrodes in the embodiment of Figure 1;
Figure 3 is a schematic illustration of the basic elements and principle of operation of the embodiment of Figure 1;
Figure 4 illustrates a first example of a resonant element assembly that can be used in the embodiment of Figure 1;
Figure 5 is a schematic illustration of two possible mode shapes for the resonant element assembly of Figure 4;
Figure 6 illustrates drive and sense circuitry for the embodiment of Figure 1;
Figure 7 illustrates a second example of a resonant element assembly;
Figure 8 is an exploded view of device layers of the embodiment of Figure 1;
Figure 9 illustrates an arrangement for detecting acceleration in a third axis; and
Figure 10 illustrates a gravimeter down a bore hole.

### Detailed Description

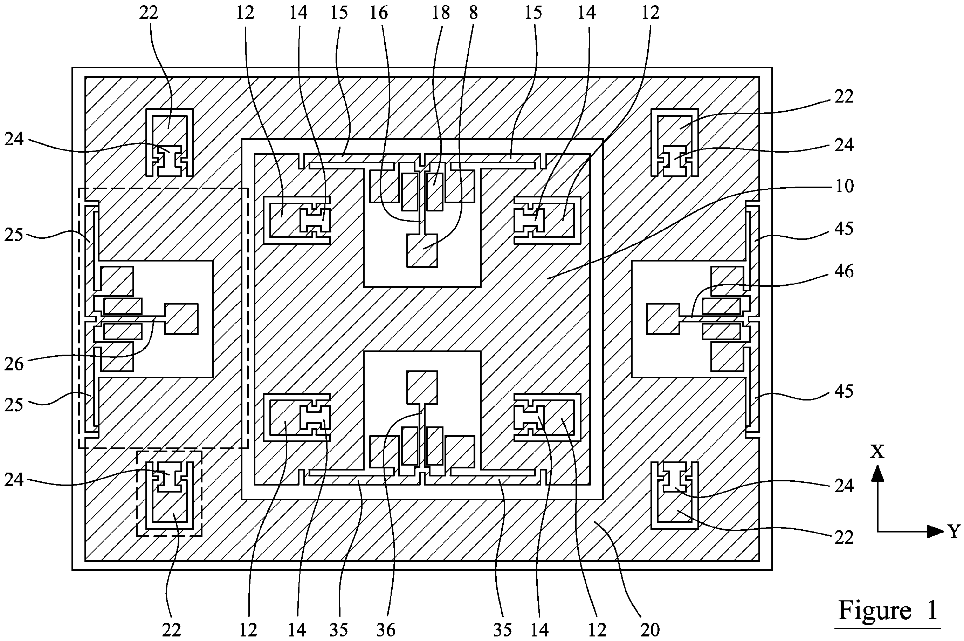

Figure 1 is a schematic illustration of a top view of an accelerometer in accordance with the present invention. The accelerometer is advantageously fabricated entirely from a single semiconductor wafer, such as a silicon-on-insulator (SOI) wafer.

The accelerometer comprises a first proof mass 10 and a second proof mass 20. The second proof mass 20 surrounds the first proof mass 10 on all sides. The center of mass of the first proof 10 is coincident with the centre of mass of the second proof mass 20. The first proof mass 10 and the second proof 20 mass have equal mass.

The first proof mass 10 and second proof mass 20 are coplanar and lie in a plane defining an X axis and a Y axis. The X and Y axes are shown in Figure 1 and are orthogonal to one another. Orthogonal to both the X and Y axis is a Z axis. The Z axis is in a direction out of the page with respect to Figure 1.

Flexures 14 couple the first proof mass 10 to fixed anchors 12 such that the first proof mass 10 is suspended from the fixed anchors 12. The fixed anchors are all part of the same frame.

A first resonator 16 of a first resonant assembly is connected between an anchor 8 on the frame and one side of the first proof mass 10 through amplifying levers 15. In operation, the first resonant element is driven to resonance by the application of an alternating current to a drive electrode 18 adjacent to the resonant element.

The second proof mass 20 is similarly suspended from fixed anchors 22 on the frame by flexures 24. A second resonator 26 of a second resonant element assembly is connected between the frame and one side of the second proof mass 20 through amplifying levers 25. In operation, the second resonant element is driven to resonance by the application of an alternating current to electrodes adjacent to the second resonant element.

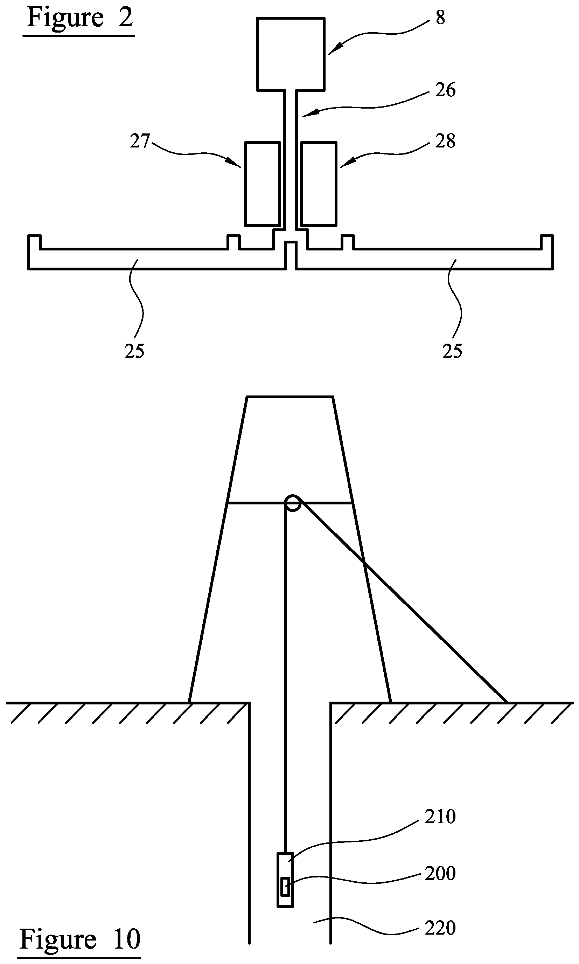

Figure 2 is an enlarged view of the second resonant element assembly of Figure 1, including the drive and sense electrodes. The second resonator 26 is connected to the frame at anchor 8 and to the second proof mass 20 (not shown) through levers 25. The resonator is driven into resonance by the application of a voltage to drive electrode 28, which is adjacent to the resonator. The frequency or amplitude, or both the frequency and amplitude, of vibration of the second resonator 26 is detected by monitoring the voltage on readout electrode 27.

By providing both a first and a second proof mass 10 and 20, the accelerometer of Figure 1 can provide a measure of acceleration in two axes, the X axis and the Y axis.

The accelerometer is sensitive to acceleration along the X axis as a result of acceleration of the first proof mass 10 along the X axis. The first resonant element experiences a force as a result of acceleration of the proof mass along the X axis. Amplifying levers 15, also referred to as a micro-levers, amplify the force applied to the first resonant element as a result of the displacement of the first proof mass along the X axis. In this way, any displacement of the proof mass along the X axis results in a strain on the first resonant element. The strain induced on the first resonant element results in a change in the resonant behaviour of the first resonant element.

The accelerometer is sensitive to acceleration along the Y axis as a result of displacement of the second proof mass 20 along the Y axis. The second resonant element experiences a force as a result of acceleration of the proof mass along the Y axis. Amplifying levers 25, also referred to as micro-levers, amplify the inertial force applied to the second resonant element as a result of the displacement of the second proof mass 20 along the Y axis. Any displacement of the proof mass along the Y axis results in a strain on the second resonant element. The strain induced on the second resonant element results in a change in the resonant behaviour of the second resonant element.

With the arrangement shown in Figure 1, the first proof mass 10 is mechanically decoupled from the second proof mass 20. Therefore, cross talk between two axes of measurement is minimised.

In the embodiment illustrated in Figure 1, identical resonator assemblies are attached at diametrically opposite sides of the first proof mass 10 along the X axis. In other words, a third resonator assembly 36 is positioned diametrically opposite the first resonator assembly and connected to the frame and to the first proof mass 10 through amplifying levers 35. Any motion of the first proof mass 10 consequently gets translated into an equal magnitude of strain on each of the oppositely positioned resonators, but of opposite polarity. By taking the difference between the output from the first resonant element assembly and the output from the third resonant element assembly, common mode effects can be rejected.

Similarly, identical resonator assemblies are attached at diametrically opposite sides of the second proof mass 20. In other words, a fourth resonator assembly 46 is positioned diametrically opposite the second resonator assembly and connected to the second proof mass 20 through amplifier levers 45. This again allows variations due to common mode effects to be rejected.

While the first and third resonator assemblies are advantageously identical to one another, the second resonant element assembly is advantageously different to the first resonator assembly. In particular the first and second resonant elements are designed to have significantly different resonant frequencies to one another. This reduces the potential for cross-talk between the outputs from the first and second resonant elements 16 and 26.

The flexures 12 and 22 that are used to suspend each of the first and second proof masses from the frame may be single beam flexures. These offer good cross-axis decoupling of the acceleration in the X axis or the Y axis respectively. However the stiffness of single beam flexures can exhibit early onset of mechanical nonlinearity (the spring hardening effect). This means that the displacement of the proof mass will not be linear with increasing acceleration at high acceleration levels and the inertial force on the resonant elements will be relatively reduced at large displacements. To improve the sensitivity of the accelerometer, folded flexure beams can be used. However, conventional folded beam designs provide limited cross-axis decoupling, making them undesirable for a single axis accelerometer. So, to improve sensitivity of the accelerometer, it is advantageous to use serpentine flexures 14, 24 to suspend the proof mass from the frame, as illustrated in Figure 1. A serpentine shape can minimise the spring hardening effect but still maintain good cross-axis decoupling. Serpentine flexures are described in more detail in WO2018/197857.

As described, the accelerometer is advantageously fabricated entirely from a single semiconductor wafer, such as a silicon-on-insulator (SOI) wafer and can be fabricated using conventional MEMS fabrication techniques, such as surface micromachining and etching. By fabricating the accelerometer from a single piece of semiconductor material, the sensitive axes can be aligned at the chip level.

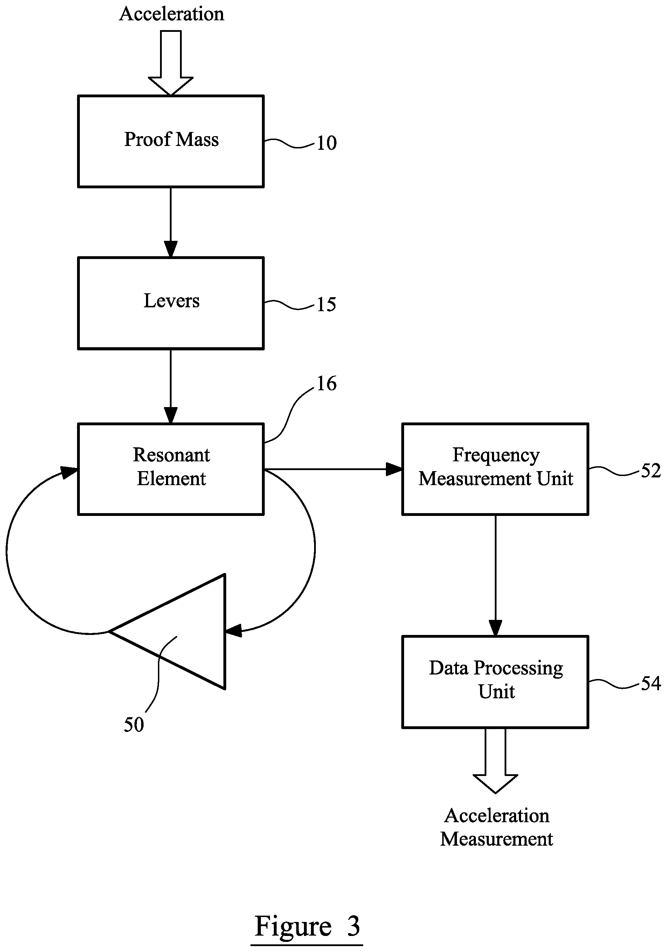

Figure 3 is a schematic illustration of the basic elements and principle of operation of the accelerometer for measuring acceleration based on changes in the resonant frequency of a resonator element. The principle of operation is described with respect to the first proof mass 10 and for measuring an acceleration in the X axis, but equally applies for measuring an acceleration in the Y axis with the second proof mass based on changes in the resonant frequency of a resonator element.

An acceleration acts on the first proof mass 10 to generate an inertial force along the X axis. The inertial force is amplified by the levers 15 to act on the resonant element of the first and third resonant element assemblies. A frequency tracking oscillator, represented in Figure 3 by amplifier 50 is used to maintain the resonant elements at a resonant frequency. Any change in resonant frequency is measured by frequency measurement unit 52 and processed using a data processing unit 54 to provide an output measured acceleration signal.

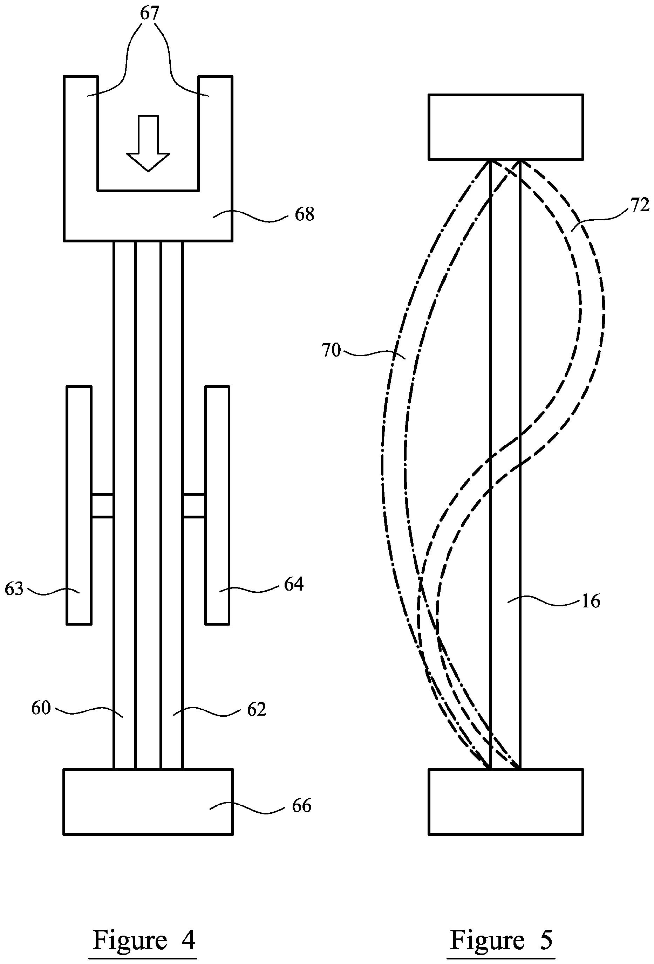

Figure 4 illustrates an example of a resonant element that can be used in the accelerometer of Figure 1. The resonant element of the resonant element assembly is a double-ended tuning fork (DETF) resonator and comprises first and second tines 60, 62 connected between a fixed anchor 66 on the frame and a floating anchor 68 which is connected to the first proof mass through the levers 15 (not shown in Figure 4). Elements 67 are connections to the amplifying levers. First and second electrodes 63 and 64 are connected to the first second tines 60 and 62 and are used to drive and sense the motion of tines. As described above, the embodiment illustrated in Figure 1 comprises identical resonator assemblies attached at diametrically opposite sides of the first proof mass 10 along the X axis and diametrically opposite sides of the second proof mass 20 along the Y axis. Any motion of the first proof mass 10 consequently gets translated into an equal magnitude of strain on each of the oppositely positioned resonators, but of opposite polarity. In other words, one resonator undergoes an axial tensile stress while the other undergoes an axial compressive stress. This arrangement allows for a differential measurement from the two diametrically opposed resonators which can then be used to provide for common mode cancellation.

In order to obtain the maximum common-mode rejection of the influence of temperature, residual stress, and cross-axis vibrations, it is advantageous for the resonant elements of the first and third (or second and fourth) resonant element assemblies to have identical geometry to one another. However, if both the first and third resonant elements are driven in the same mode of vibration, then problems can arise. In particular, manufacturing tolerances means that the two resonant elements will never have exactly the same resonant frequency for a given mode of vibration. The resulting currents signals from the two resonant elements have very similar but not identical frequencies. When used together in a differential output scheme this can lead to issues such as mode-shape distortion, injection locking and signal cross-talk because of unavoidable mechanical and electrical coupling effects in the accelerometer.

To address this issue, the accelerometer of Figure 1 is configured to drive the resonant element of the first resonant element assembly in a different mode to the resonant element of the third resonant element assembly, the different modes having different resonant frequencies, but using the same electrode arrangement for both resonant elements. This preserves the symmetry of the mechanical structure and removes any restriction on which of the resonant elements should operate in which mode.

In one embodiment, one of the first and third resonant elements is driven to vibrate in a fundamental mode and the other of the first and third resonant elements is driven to vibrate in a second order mode. Figure 5 illustrates in an exaggerated form, the shape of the fundamental mode of vibration 70 and a second order mode of vibration 72. The two modes have different resonant frequencies but both can be excited independently by a single pair of adjacent drive electrodes.

Modes other than the modes illustrated in Figure 5 can be used, and different forms of resonant element can be used. However, there is an advantage to an arrangement which preserves the symmetry of the physical structure of the accelerometer. Different modes will give rise to different scale factors. In other words, for a given input acceleration the frequency shift of the resonant frequency will be greater for one mode than the other. The overall scale factor for the accelerometer along that axis will be the average of the two. The use of higher order modes can be advantageous because they will typically give rise to higher scale factors.

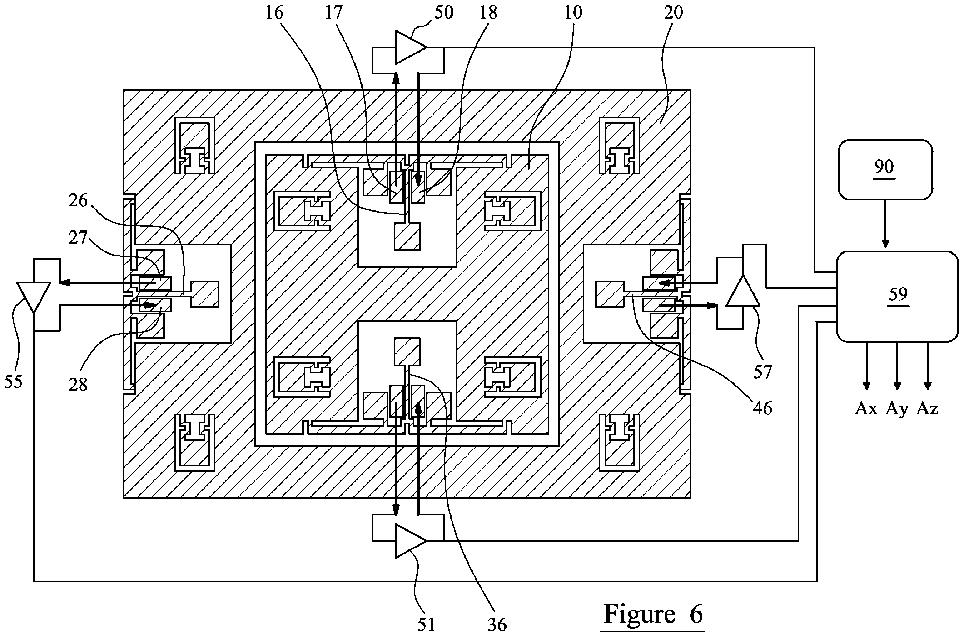

Figure 6 illustrates in more detail the drive and sense circuitry used to produce output signals that are measures of acceleration along the X and Y axes. As described with reference to Figures 2 and 3, each resonant element is driven by a drive electrode and the vibratory response sensed by a sense electrode. A frequency tracking oscillator is used for each resonant element to provide feedback control in order to maintain each resonant element at resonance. The resonant frequency of each resonant element, which will vary depending on the strain experienced by that resonant element, and the amplitude of vibration of each resonant element is provided as an output from each frequency tracking oscillator. As shown in Figure 5 the first resonant element 16 is driven by drive electrode 18, and the response sensed by sense electrode 17. The oscillator 50 maintains the first resonator in resonance and outputs the resonant frequency to the multi-axis processing circuit 59. An identical arrangement is used for the third resonator assembly 36, with the oscillator 51 maintaining the third resonator in resonance and outputting the resonant frequency to the multi-axis processing circuit 59. The multi-axis processing circuit 59 uses the difference between the output from the oscillator 50 and the output from the oscillator 51, having adjusted for any scale factor difference, to provide a measure of acceleration Ax along the X axis.

The same arrangement is used for second and fourth resonator assemblies. The second resonant element 26 is driven by drive electrode 28, and the response sensed by sense electrode 27. The oscillator 55 maintains the second resonator in resonance and outputs the resonant frequency to the multi-axis processing circuit 59. The oscillator 57 maintains the fourth resonator assembly 46 in resonance and outputs the resonant frequency to the multi-axis processing circuit 59. The multi-axis processing circuit 59 uses the difference between the output from the oscillator 55 and the output from the oscillator 57, having adjusted for any scale factor difference, to provide a measure of acceleration Ay along the Y axis.

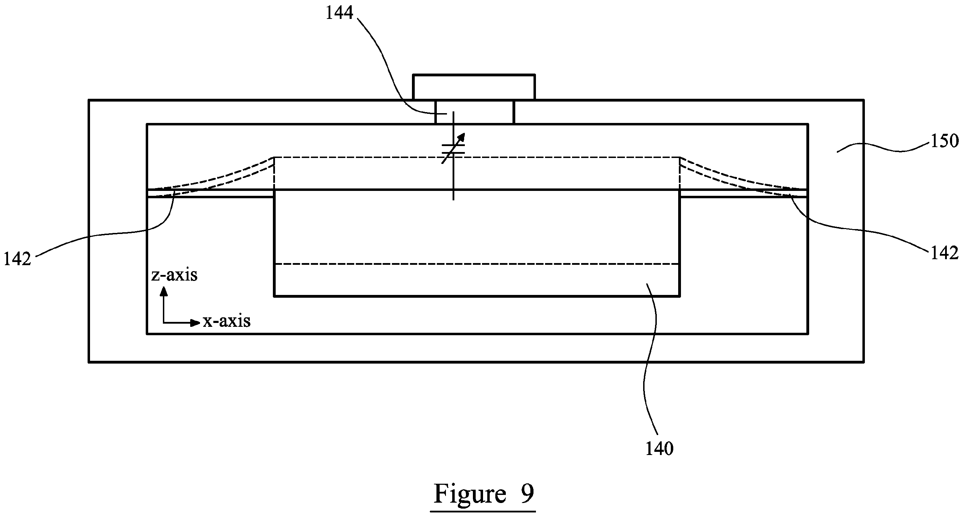

A measure of acceleration in the Z-axis can also be obtained using an arrangement described below, with reference to Figure 9. An output from the Z-axis electrode or electrodes can be provided to the multi-axis processing circuit 59.

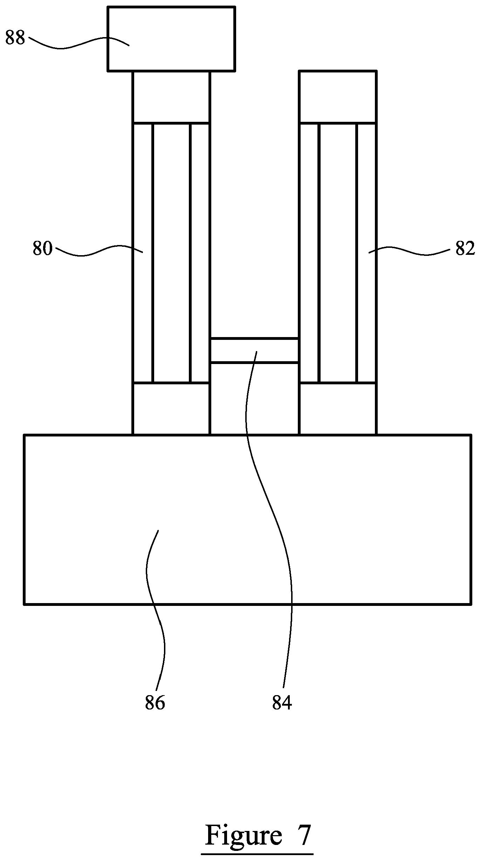

Figure 7 illustrates an alternative example of a resonant element assembly. Rather than relying on frequency shift of the resonant frequency to measure acceleration, the resonant element assembly of Figure 7 exploits the phenomenon of mode localization in two weakly coupled resonant elements.

As described above, an acceleration acts on the first proof mass 10 to generate an inertial force along the X axis. However, in this arrangement, each resonant element assembly comprises two resonant elements. A first resonator element 80 is connected between a fixed anchor 86 on the frame and a floating anchor 88 which is connected to the first proof mass through the one of the levers 15 (not shown in Figure 7). A second resonant element 82, identical to the first resonant element 80, is coupled to the first resonant element 80 by a mechanical coupling 84. The second resonant element is connected on one end to the fixed anchor 86 and at the other end to the other amplifying lever 15, identical to the other amplifying lever 15, but not to the proof mass. This provides structural symmetry between the first and second resonant elements.

In operation, the resonant elements 80, 82 are driven to resonance by the application of an alternating voltage to the drive electrodes. The mechanical coupling between the resonant elements in each pair is only a weak coupling. When two vibrating resonant elements are weakly coupled in this way, any change in stiffness of one resonant element relative to the other leads to significant changes in the relative amplitude of vibration of the two coupled resonators. By monitoring the ratio of the amplitude of vibration of the resonant elements 80, 82, a measure of acceleration of the proof mass can be obtained. This can be achieved either by measuring the amplitudes of both the resonant elements and comparing the two, or by controlling the amplitude of vibration of one of the resonant elements to be constant using feedback control, and measuring the amplitude of vibration of the other. This phenomenon is called mode localization and is explained in detail in WO2011/148137.

While Figure 7 shows a mechanical coupling between the two vibrating resonant elements, the means for coupling may instead by an electrostatic coupling means.

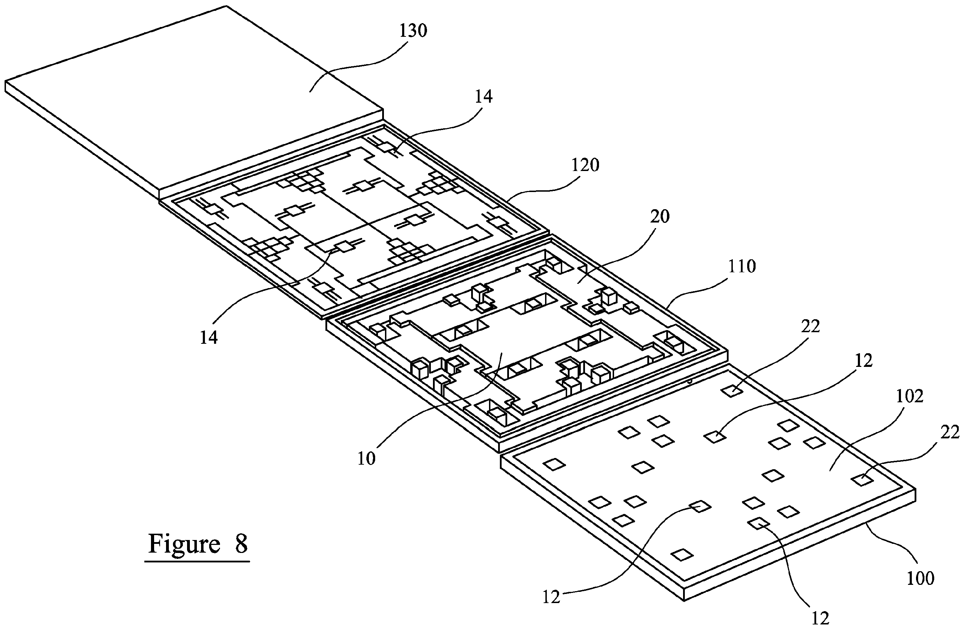

As described, an accelerometer in accordance with the invention may advantageously be made from a single silicon wafer. Figure 8 illustrates four layers of a silicon accelerometer having a layout as shown in Figure 1. Each layer extends in the plane defined by the X and Y direction, as already described.

Base layer 100 forms the base of the accelerometer. This base layer comprises a frame 102 in which the fixed anchors 12 and 22 are defined.

Layers 110 and 120 are lower and upper intermediate layers of the accelerometer. The fixed anchors 12 and 22 are defined in both layer 110 and layer 120. The lower intermediate layer 110 has voids around the areas defining the first proof mass 10 and the second proof mass 20. Each of the proof masses is shaped around the fixed anchors. Furthermore, there are spaces provided to allow for movement of the flexures, resonant element assemblies and levers in the upper intermediate layer, as well as spaces allowing for displacement of the proof masses in response to acceleration in either the X direction or the Y direction.

The upper intermediate layer 120 provides the flexures, resonant element assemblies and levers, which are connected to the first and second proof masses 10 and 20. The flexures are connected to the proof masses at one end and to the fixed anchors at the other. The first and second proof masses can move relative to the frame. A comparison of the lower intermediate layer 110 with the upper intermediate layer 120 illustrates the relative thickness of the proof masses 10 and 20 compared to other features such as the flexures. This is so that the proof masses have as large a mass as possible within the confines of the device. Larger proof masses provide for greater device sensitivity.

The top layer 130 is a cap layer of the accelerometer and seals the moving parts from the environment.

Figure 9 illustrates an arrangement for detecting acceleration in a third axis using the first or second proof mass of the embodiment of Figure 1. Figure 9 is a schematic cross-section through an accelerometer, showing the proof mass 140 suspended from a frame 150 by flexures 142. A Z-axis drive and sense electrode 144 is provided in the cap layer of the frame 150, above the proof mass 140. The proof mass is able to move along the Z-axis on the flexures 142, as illustrated by the dotted line in response to an applied acceleration along the z-axis. As the distance between the proof mass 140 and the electrode 144 varies, so will the capacitance between the proof mass 140 and the electrode 144.

In one arrangement, the value of the variable capacitance between the proof mass 140 and the electrode 144 is used as a measure of acceleration. In another embodiment, the electrode 144 may be used to drive the proof mass and flexure assembly into a resonant vibration along the z-axis by the application of a drive voltage. Any external acceleration in the Z-axis direction will result in an additional strain on the flexures 142, altering the resonant frequency of the proof mass and flexure assembly. As with the X and Y axis readouts, a frequency tracking oscillator can be used to provide an output signal to the multi-axis processing circuit 59, shown in Figure 6. A measure of acceleration in the Z-axis direction can thus be obtained.

As well as providing a measure of acceleration in the Z-axis direction, one or more electrodes in the cap layer can be used to correct small tilts of the device relative to the gravity field. By applying electrostatic forces on the first and second proof masses, the accelerometer can be correctly aligned.

An accelerometer as described can be used for many applications. One example is as a gravimeter. A gravimeter can be used for surveying in oil or gas extraction. Figure 10 illustrates a gravimeter down a bore hole. Measurements of the gravity field down a borehole can provide information about the density of the surrounding layers and so information about the presence of oil or gas reserves and their size and location. This requires measurement of gravitational filed in three dimensions. A shown in Figure 10, an accelerometer 200 in accordance with the invention is positioned within a borehole tool 210. The borehole tool is placed in the bore, suspended from a suitable structure on the surface. Gravimeters of this sort can be used in other applications, such as carbon storage monitoring, monitoring groundwater depletion, discovery of underwater aquifers, monitoring other processes underpinning the hydrological cycle, early-warning systems for earthquake-prone zones or for areas impacted by volcanic activity.

## Claims

1. An accelerometer comprising:
a frame (102);
a first proof mass (10) suspended from the frame by one or more flexures (14) to move relative to the frame along a first axis;
a first resonant element assembly fixed between the frame and the first proof mass, wherein movement of the proof mass along the first axis relative to the frame exerts a strain on the first resonant element (16) that affects the resonant behaviour of the first resonant element assembly; **characterised in**
a second proof mass (20) suspended from the frame by one or more flexures (24) to move relative to the frame along a second axis,
a second resonant element assembly fixed between the frame and the second proof mass, wherein movement of the proof mass along the second axis relative to the frame exerts a strain on the second resonant element (26) that affects the resonant behaviour of the second resonant element assembly;
wherein the second proof mass surrounds the first proof mass and the first resonant element assembly.

2. An accelerometer according to claim 1, wherein a centre of mass of the first proof mass (10) is substantially coincident with a centre of mass of the second proof mass (20).

3. An accelerometer according to claim 1 or 2, wherein the first proof mass (10) and the second proof mass (20) are coplanar and lie in a plane defined by first and second axes.

4. An accelerometer according to any one of the preceding claims, wherein the first and second axes are orthogonal to one another.

5. An accelerometer according to any one of the preceding claims, wherein the first proof mass (10) and second proof mass (20) are of substantially equal mass.

6. An accelerometer according to any one of the preceding claims, wherein the accelerometer is a micro electrical mechanical systems (MEMS) device.

7. An accelerometer according to any one of the preceding claims, wherein the frame (102), first proof mass (10), second proof mass (20) and flexures (14, 24) are formed from a single piece of semiconductor material.

8. An accelerometer according to claim 7, wherein the resonant element assemblies are formed from the single piece of semiconductor material.

9. An accelerometer according to any one of the preceding claims, comprising a third resonant element assembly fixed between the frame (102) and the first proof mass (10), wherein movement of the proof mass along the first axis relative to the frame exerts a strain on the third resonant element (36) that affects the resonant behaviour of the third resonant element assembly.

10. An accelerometer according to claim 9, wherein the third resonant element assembly is substantially identical to the first resonant element assembly and is fixed on an opposite side of the first proof mass (10) to the first resonant assembly in the direction of the first axis.

11. An accelerometer according to any one of the preceding claims, comprising a fourth resonant element assembly fixed between the frame (102) and the second proof mass, wherein movement of the proof mass along the second axis relative to the frame exerts a strain on the fourth resonant element (46) that affects the resonant behaviour of the fourth resonant element assembly.

12. An accelerometer according to claim 11, wherein the fourth resonant element assembly is substantially identical to the second resonant element assembly and is fixed on an opposite side of the second proof mass (20) to the second resonant assembly in the direction of the second axis.

13. An accelerometer according to any one of the preceding claims, wherein one or more of the resonant element assemblies comprises a pair of coupled resonant elements.

14. An accelerometer according to any one of the preceding claims, comprising one or more electrodes (144) adjacent the first proof mass (10) or second proof mass (20) and spaced from the first proof mass or the second proof mass along a third axis orthogonal to the first axis and the second axis.

15. A gravimeter comprising an accelerometer according to any one of the preceding claims.

## Patentansprüche

1. Beschleunigungsmesser, umfassend:
einen Rahmen (102);
eine erste Prüfmasse (10), die durch ein oder mehrere Biegeelemente (14) am Rahmen aufgehängt ist, um sich relativ zum Rahmen entlang einer ersten Achse zu bewegen,
eine erste Resonanzelementanordnung, die zwischen dem Rahmen und der ersten Prüfmasse befestigt ist,
wobei die Bewegung der Prüfmasse entlang der ersten Achse relativ zu dem Rahmen eine Beanspruchung auf das erste Resonanzelement (16) ausübt, die das Resonanzverhalten der ersten Resonanzelementanordnung beeinflusst; **gekennzeichnet durch**
eine zweite Prüfmasse (20), die durch ein oder mehr Biegeelemente (23) am Rahmen aufgehängt ist, um sich relativ zum Rahmen entlang einer zweiten Achse zu bewegen,
eine zweite Resonanzelementanordnung, die zwischen dem Rahmen und der zweiten Prüfmasse befestigt ist, wobei die Bewegung der Prüfmasse entlang der zweiten Achse relativ zum Rahmen eine Beanspruchung auf das zweite Resonanzelement (26) ausübt, die das Resonanzverhalten der zweiten Resonanzelementanordnung beeinflusst;
wobei die zweite Prüfmasse die erste Prüfmasse und die erste Resonanzelementanordnung umgibt.

2. Beschleunigungsmesser nach Anspruch 1, wobei ein Massenmittelpunkt der ersten Prüfmasse (10) im Wesentlichen mit einem Massenmittelpunkt der zweiten Prüfmasse (20) übereinstimmt.

3. Beschleunigungsmesser nach Anspruch 1 oder 2, wobei die erste Prüfmasse (10) und die zweite Prüfmasse (20) komplanar sind und in einer Ebene liegen, die von der ersten und der zweiten Achse definiert wird.

4. Beschleunigungsmesser nach einem der vorhergehenden Ansprüche, wobei die erste und die zweite Achse zueinander orthogonal sind.

5. Beschleunigungsmesser nach einem der vorhergehenden Ansprüche, wobei die erste Prüfmasse (10) und die zweite Prüfmasse (20) von im Wesentlichen gleicher Masse sind.

6. Beschleunigungsmesser nach einem der vorhergehenden Ansprüche, wobei der Beschleunigungsmesser eine Mikrosystem- (MEMS) -Vorrichtung ist.

7. Beschleunigungsmesser nach einem der vorhergehenden Ansprüche, wobei der Rahmen (102), die erste Prüfmasse (10), die zweite Prüfmasse (20) und die Biegeelemente (14, 24) aus einem einzelnen Halbleitermaterialstück gebildet sind.

8. Beschleunigungsmesser nach Anspruch 7, wobei die Resonanzelementanordnungen aus dem einzelnen Halbleitermaterialstück gebildet sind.

9. Beschleunigungsmesser nach einem der vorhergehenden Ansprüche, der eine dritte Resonanzelementanordnung aufweist, die zwischen dem Rahmen (102) und der ersten Prüfmasse (10) befestigt ist, wobei die Bewegung der Prüfmasse entlang der ersten Achse relativ zu dem Rahmen eine Beanspruchung auf das dritte Resonanzelement (36) ausübt, die das Resonanzverhalten der dritten Resonanzelementanordnung beeinflusst.

10. Beschleunigungsmesser nach Anspruch 9, wobei die dritte Resonanzelementanordnung mit der ersten Resonanzelementanordnung im Wesentlichen identisch ist und auf einer der ersten Prüfmasse (10) entgegengesetzten Seite an der ersten Resonanzanordnung in Richtung der ersten Achse befestigt ist.

11. Beschleunigungsmesser nach einem der vorhergehenden Ansprüche, der eine vierte Resonanzelementanordnung aufweist, die zwischen dem Rahmen (102) und der zweiten Prüfmasse befestigt ist, wobei die Bewegung der Prüfmasse entlang der zweiten Achse relativ zu dem Rahmen eine Beanspruchung auf das vierte Resonanzelement (46) ausübt, die das Resonanzverhalten der vierten Resonanzelementanordnung beeinflusst.

12. Beschleunigungsmesser nach Anspruch 11, wobei die vierte Resonanzelementanordnung im Wesentlichen mit der zweiten Resonanzelementanordnung identisch ist und auf einer der zweiten Prüfmasse (20) entgegengesetzten Seite an der zweiten Resonanzanordnung in Richtung der zweiten Achse befestigt ist.

13. Beschleunigungsmesser nach einem der vorhergehenden Ansprüche, wobei eine oder mehr der Resonanzelementanordnungen ein Paar gekoppelter Resonanzelemente aufweisen.

14. Beschleunigungsmesser nach einem der vorhergehenden Ansprüche, der eine oder mehr Elektroden (144) aufweist, die an die erste Prüfmasse (10) oder die zweite Prüfmasse (20) angrenzen und von der ersten Prüfmasse oder der zweiten Prüfmasse entlang einer dritten Achse, die zu der ersten Achse und der zweiten Achse orthogonal ist, beabstandet sind.

15. Gravimeter, das einen Beschleunigungsmesser nach einem der vorhergehenden Ansprüche aufweist.

## Revendications

1. Accéléromètre comprenant :
un cadre (102) ;
une première masse étalon (10) suspendue au cadre par une ou plusieurs pièces de flexion (14) pour se déplacer par rapport au cadre le long d'un premier axe ;
un premier ensemble d'élément résonnant fixé entre le cadre et la première masse étalon, dans lequel le mouvement de la masse étalon le long du premier axe par rapport au cadre exerce une contrainte sur le premier élément résonnant (16) qui affecte le comportement de résonance du premier ensemble d'élément résonnant ; **caractérisé par**
une seconde masse étalon (20) suspendue au cadre par une ou plusieurs pièces de flexion (24) pour se déplacer par rapport au cadre le long d'un deuxième axe,
un deuxième ensemble d'élément résonnant fixé entre le cadre et la seconde masse étalon, dans lequel le mouvement de la masse étalon le long du deuxième axe par rapport au cadre exerce une contrainte sur le second élément résonnant (26) qui affecte le comportement de résonance du deuxième ensemble d'élément résonnant ;
dans lequel la seconde masse étalon entoure la première masse étalon et le premier ensemble d'élément résonnant.

2. Accéléromètre selon la revendication 1, dans lequel un centre de masse de la première masse étalon (10) coïncide sensiblement avec un centre de masse de la seconde masse étalon (20).

3. Accéléromètre selon la revendication 1 ou 2, dans lequel la première masse étalon (10) et la seconde masse étalon (20) sont coplanaires et se trouvent dans un plan défini par des premier et deuxième axes.

4. Accéléromètre selon l'une quelconque des revendications précédentes, dans lequel les premier et deuxième axes sont orthogonaux l'un à l'autre.

5. Accéléromètre selon l'une quelconque des revendications précédentes, dans lequel la première masse étalon (10) et la seconde masse étalon (20) sont d'une masse sensiblement égale.

6. Accéléromètre selon l'une quelconque des revendications précédentes, dans lequel l'accéléromètre est un dispositif de microsystème électromécanique (MEMS).

7. Accéléromètre selon l'une quelconque des revendications précédentes, dans lequel le cadre (102), la première masse étalon (10), la seconde masse étalon (20) et les pièces de flexion (14, 24) sont formés à partir d'une seule pièce de matériau semi-conducteur.

8. Accéléromètre selon la revendication 7, dans lequel les ensembles d'éléments résonnants sont formés à partir d'une seule pièce de matériau semi-conducteur.

9. Accéléromètre selon l'une quelconque des revendications précédentes, comprenant un troisième ensemble d'élément résonnant fixé entre le cadre (102) et la première masse étalon (10), dans lequel le mouvement de la masse étalon le long du premier axe par rapport au cadre exerce une contrainte sur le troisième élément résonnant (36) qui affecte le comportement de résonance du troisième ensemble d'élément résonnant.

10. Accéléromètre selon la revendication 9, dans lequel le troisième ensemble d'élément résonnant est sensiblement identique au premier ensemble d'élément résonnant et est fixé sur un côté opposé de la première masse étalon (10) au premier ensemble résonnant dans la direction du premier axe.

11. Accéléromètre selon l'une quelconque des revendications précédentes, comprenant un quatrième ensemble d'élément résonnant fixé entre le cadre (102) et la seconde masse étalon, dans lequel le mouvement de la masse étalon le long du deuxième axe par rapport au cadre exerce une contrainte sur le quatrième élément résonnant (46) qui affecte le comportement de résonance du quatrième ensemble d'élément résonnant.

12. Accéléromètre selon la revendication 11, dans lequel le quatrième ensemble d'élément résonnant est sensiblement identique au deuxième ensemble d'élément résonnant et est fixé sur un côté opposé de la seconde masse étalon (20) au deuxième ensemble résonnant dans la direction du deuxième axe.

13. Accéléromètre selon l'une quelconque des revendications précédentes, dans lequel un ou plusieurs des ensembles d'éléments résonnants comprennent une paire d'éléments résonnants couplés.

14. Accéléromètre selon l'une quelconque des revendications précédentes, comprenant une ou plusieurs électrodes (144) adjacentes à la première masse étalon (10) ou à la seconde masse étalon (20) et espacées de la première masse étalon ou de la seconde masse étalon le long d'un troisième axe orthogonal au premier axe et au deuxième axe.

15. Gravimètre comprenant un accéléromètre selon l'une quelconque des revendications précédentes.
